# EUROPEAN PATENT APPLICATION

(11) **EP 4 550 414 A1**
(43) Date of publication of application: **07.05.2025**
(21) Application number: 24202667.2
(22) Date of filing: 25.09.2024
(51) Int. Cl.: H01L 23/498, H01L 23/538, H01L 21/48

(54) **DOUBLE-SIDED CONDUCTIVE VIA**

(30) Priority: 31.10.2023 US 202318498519
(71) Applicant: INTEL Corporation, Santa Clara, CA 95054 (US)
(72) Inventor: AMIN, Payam, Portland, 97229 (US); SIBAKOTI, Mandip, Hillsboro, 97123 (US); MARINKOVIC, Bozidar, Portland, 97225 (US); RAHMAN, MD Tofizur, Portland, 97229 (US); PULS, Conor P., Portland, 97229 (US)
(74) Representative: 2SPL Patentanwälte PartG mbB

(57) **Abstract**

A fabrication method and associated integrated circuit (IC) structures and devices that include one or more conductive vias is described herein. In one example, a conductive via is formed from one side of the integrated circuit, and then a portion of the conductive via is widened from a second side of the IC structure opposite the first side. In one example, a resulting IC structure includes a first portion having a first width, a second portion having a second width, and a third portion having a third width, wherein the third portion is between the first portion and the second portion, and the third width is smaller than the first width and the second width. In one such example, the conductive via tapers from both ends towards the third portion between the ends.

## Description

### Background

For the past several decades, the scaling of features in integrated circuits (ICs) has been a driving force behind an ever-growing semiconductor industry. Scaling to smaller and smaller features enables increased densities of functional units on the limited real estate of semiconductor chips. For example, shrinking transistor size allows for the incorporation of an increased number of memory or logic devices on a chip, lending to the fabrication of products with increased capacity. The drive for the ever-increasing capacity, however, is not without issue. The necessity to optimize fabrication and performance of each component (e.g., the conductive interconnects for signaling, power delivery, and ground) is becoming increasingly significant.

### Brief Description of the Drawings

Embodiments will be readily understood by the following detailed description in conjunction with the accompanying drawings.
FIGS. 1A-1C provide cross-sectional side views illustrating examples of integrated circuit (IC) structures that include a double-sided conductive via, according to embodiments of the present disclosure.
FIG. 2 is a flow diagram of an example method for fabricating an IC structure that includes a double-sided conductive via, in accordance with some embodiments.
FIGS. 3A-3G provide cross-sectional side views at various stages in the fabrication of an example IC structure according to the method of FIG. 2, in accordance with some embodiments.
FIG. 4 is a flow diagram of an example method for fabricating an IC structure that includes a double-sided conductive via, in accordance with some embodiments.
FIGS. 5A-5H provide cross-sectional side views at various stages in the fabrication of an example IC structure according to the method of FIG. 4, in accordance with some embodiments.
FIG. 6 is a top view of a wafer and dies that may include any of the IC structures disclosed herein, in accordance with any of the embodiments disclosed herein.
FIG. 7 is a side, cross-sectional view of an IC device that may include any of the IC structures disclosed herein, in accordance with any of the embodiments disclosed herein.
FIG. 8 is a side, cross-sectional view of an IC package that may include any of the IC structures disclosed herein, in accordance with various embodiments.
FIG. 9 is a side, cross-sectional view of an IC device assembly that may include any of the IC structures disclosed herein, in accordance with any of the embodiments disclosed herein.
FIG. 10 is a block diagram of an example electrical device that may include any of the IC structures disclosed herein, in accordance with any of the embodiments disclosed herein.

### Detailed Description

Disclosed herein is a fabrication method and associated IC structures and devices that include one or more double-sided conductive vias. The systems, methods and devices of this disclosure each have several innovative aspects, no single one of which is solely responsible for all desirable attributes disclosed herein. Details of one or more implementations of the subject matter described in this specification are set forth in the description below and the accompanying drawings.

As briefly described above, scaling down features in ICs has fueled the semiconductor industry's growth. Smaller features mean more functions on chips, boosting capacity. Optimizing fabrication and performance of each individual component is crucial in the pursuit of greater capacity. One factor limiting performance is the aspect ratio of conductive vias. Conventionally, vias are patterned in one step, resulting in an etched-trench profile where one side of the via is wider than the other. For example, the via opening may taper from the top towards the bottom of the via opening, resulting in a smaller width at its bottom than at its top. Thus, conventional vias can have a V-shape or a trapezoidal cross-section (e.g., a cross-section of the via may have two parallel sides, one of which is a short side and another one of which is a long side).

This width reduction along the full height of the via trench can result in higher vertical resistance as well as higher contact resistance at the narrower side (e.g., at the bottom of the via). The increased resistance can be especially problematic for high aspect ratio vias, which can have one side that is significantly narrower than the other side. Increased resistance in a conductive via can result in a number of undesirable effects that may affect device performance, including increased power consumption and heat dissipation, signal delay, reduced signal integrity, and crosstalk (e.g., unwanted interference between neighboring components).

In contrast to conventional techniques for forming vias, double-sided via processing can enable the formation of vias with a larger minimum width and a greater total volume of conductive fill material. Unlike conventional vias that have a V-shaped profile or a trapezoidal cross-section, in one example, a double-sided via is wider at both ends than at a portion between the ends of the via. Thus, in one example, a double-sided via can have sidewalls that are straighter and/or wider than conventional vias. In some examples, double-sided vias may have a cross-section that resembles an hourglass shape and/or that tapers in from both ends towards a portion between the two ends. Forming a double-sided via can involve, for example, forming an opening in one or more layers over a first side of a substrate (e.g., from a front side), flipping over the substrate to reveal a second side of the substrate (e.g., a back side), and widening a portion of the opening from the second side. The widened opening can then be filled with a conductive material. The term "double-sided via" is used herein for ease of reference to refer to a conductive via in accordance with examples described herein. The terms via, interconnect, and conductive interconnect may be used in reference to a conductive via in accordance with examples herein.

IC structures as described herein, in particular IC structures that include double-sided conductive vias, may be implemented in one or more components associated with an IC or/and between various such components. In various embodiments, components associated with an IC include, for example, transistors, diodes, power sources, resistors, capacitors, inductors, sensors, transceivers, receivers, antennas, etc. Components associated with an IC may include those that are mounted on IC or those connected to an IC. The IC may be either analog or digital and may be used in a number of applications, such as microprocessors, optoelectronics, logic blocks, audio amplifiers, etc., depending on the components associated with the IC. In some embodiments, IC structures as described herein may be included in a radio frequency IC (RFIC), which may, e.g., be included in any component associated with an IC of an RF receiver, an RF transmitter, or an RF transceiver, e.g., as used in telecommunications within base stations (BS) or user equipment (UE). Such components may include, but are not limited to, power amplifiers, low-noise amplifiers, RF filters (including arrays of RF filters, or RF filter banks), switches, upconverters, downconverters, and duplexers. In some embodiments, IC structures as described herein may be included in memory devices or circuits. In some embodiments, IC structures as described herein may be employed as part of a chipset for executing one or more related functions in a computer.

For purposes of explanation, specific numbers, materials and configurations are set forth in order to provide a thorough understanding of the illustrative implementations. However, it will be apparent to one skilled in the art that the present disclosure may be practiced without the specific details or/and that the present disclosure may be practiced with only some of the described aspects. In other instances, well-known features are omitted or simplified in order not to obscure the illustrative implementations. The terms "substantially," "close," "approximately," "near," and "about," generally refer to being within +/-10% of a target value, e.g., within +/- 5% of a target value, based on the context of a particular value as described herein or as known in the art. Similarly, terms indicating orientation of various elements, e.g., "coplanar," "perpendicular," "orthogonal," "parallel," or any other angle between the elements, generally refer to being within +/-10% of a target value, e.g., within +/- 5% of a target value, based on the context of a particular value as described herein or as known in the art.

In the following description, references are made to the accompanying drawings that form a part hereof, and in which is shown, by way of illustration, embodiments that may be practiced. It is to be understood that other embodiments may be utilized, and structural or logical changes may be made without departing from the scope of the present disclosure. Therefore, the following detailed description is not to be taken in a limiting sense.

In the drawings, while some schematic illustrations of example structures of various devices and assemblies described herein may be shown with precise right angles and straight lines, this is simply for ease of illustration, and embodiments of these assemblies may be curved, rounded, or otherwise irregularly shaped as dictated by, and sometimes inevitable due to, the fabricating processes used to fabricate semiconductor device assemblies. Therefore, it is to be understood that such schematic illustrations may not reflect real-life process limitations which may cause the features to not look so "ideal" when any of the structures described herein are examined using e.g., scanning electron microscopy (SEM) images or transmission electron microscope (TEM) images. In such images of real structures, possible processing defects could also be visible, e.g., not-perfectly straight edges of materials, tapered vias or other openings, inadvertent rounding of corners or variations in thicknesses of different material layers, occasional screw, edge, or combination dislocations within the crystalline region, and/or occasional dislocation defects of single atoms or clusters of atoms. There may be other defects not listed here but that are common within the field of device fabrication. Inspection of layout and mask data and reverse engineering of parts of a device to reconstruct the circuit using e.g., optical microscopy, TEM, or SEM, and/or inspection of a cross-section of a device to detect the shape and the location of various device elements described herein using, e.g., Physical Failure Analysis (PFA) would allow determination of presence of IC structures with double-sided vias as described herein.

Various aspects of the illustrative implementations will be described using terms commonly employed by those skilled in the art to convey the substance of their work to others skilled in the art. For example, the terms "oxide," "carbide," "nitride," "silicide," etc. refer to compounds containing, respectively, oxygen, carbon, nitrogen, silicon, etc.; the term "high-k dielectric" refers to a material having a higher dielectric constant than silicon oxide; the term "low-k dielectric" refers to a material having a lower dielectric constant than silicon oxide. Materials referred to herein with formulas or as compounds cover all materials that include elements of the formula or a compound, e.g., TiSi or titanium silicide may refer to any material that includes titanium and silicon, WN or tungsten nitride may refer to any material that includes tungsten and nitrogen, etc. The term "insulating" means "electrically insulating," the term "conducting" means "electrically conducting," unless otherwise specified. Furthermore, the term "connected" may be used to describe a direct electrical or magnetic connection between the things that are connected, without any intermediary devices, while the term "coupled" may be used to describe either a direct electrical or magnetic connection between the things that are connected, or an indirect connection through one or more passive or active intermediary devices. A first component described to be electrically coupled to a second component means that the first component is in conductive contact with the second component (i.e., that a conductive pathway is provided to route electrical signals/power between the first and second components).

Various operations may be described as multiple discrete actions or operations in turn, in a manner that is most helpful in understanding the claimed subject matter. However, the order of description should not be construed as to imply that these operations are necessarily order dependent. These operations may not be performed in the order of presentation. Operations described may be performed in a different order from the described embodiment. Various additional operations may be performed, and/or described operations may be omitted in additional embodiments.

For the purposes of the present disclosure, the phrase "A and/or B" means (A), (B), or (A and B). For the purposes of the present disclosure, the phrase "A, B, and/or C" means (A), (B), (C), (A and B), (A and C), (B and C), or (A, B, and C). The term "between," when used with reference to measurement ranges, is inclusive of the ends of the measurement ranges.

The description uses the phrases "in an embodiment" or "in embodiments," which may each refer to one or more of the same or different embodiments. The terms "comprising," "including," "having," and the like, as used with respect to embodiments of the present disclosure, are synonymous. The disclosure may use perspective-based descriptions such as "above," "below," "top," "bottom," and "side"; such descriptions are used to facilitate the discussion and are not intended to restrict the application of disclosed embodiments. The accompanying drawings are not necessarily drawn to scale. Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner. Although some materials may be described in singular form, such materials may include a plurality of materials, e.g., a semiconductor material may include two or more different semiconductor materials.

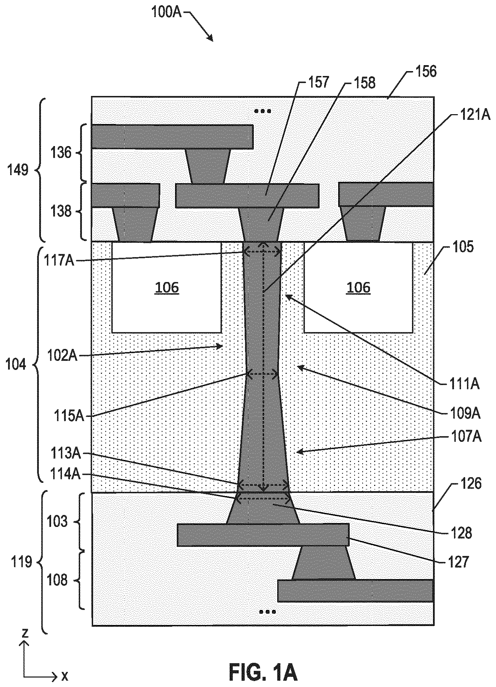

FIGS. 1A-1C are cross-sectional side views illustrating examples of IC structures that include a double-sided conductive via, according to embodiments of the present disclosure. Turning to FIG. 1A, the conductive via 102A extends through one or more layers to electrically couple conductive elements in layers above and below the conductive via 102A. The conductive via 102A may be used for signaling, power delivery (e.g., a power via), or ground. The conductive via 102A is surrounded by an insulator material 105, such as any suitable interlayer dielectric (ILD) material. In some embodiments, such an insulator material 105 may be a high-k dielectric including elements such as hafnium, silicon, oxygen, titanium, tantalum, lanthanum, aluminum, zirconium, barium, strontium, yttrium, lead, scandium, niobium, and zinc. Examples of high-k materials that may be used for this purpose may include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, tantalum oxide, tantalum silicon oxide, lead scandium tantalum oxide, and lead zinc niobate. In other embodiments, the insulator material 105 may be a low-k dielectric material. Some examples of low-k dielectric materials include, but are not limited to, silicon dioxide, carbon-doped oxide, silicon nitride, organic polymers such as perfluorocyclobutane or polytetrafluoroethylene, fused silica glass (FSG), and organosilicates such as silsesquioxane, siloxane, or organosilicate glass.

In the example illustrated in FIG. 1A, the conductive via 102A is in a device region 104 that includes one or more devices 106 such as transistors or other IC devices. The conductive via 102A may be in the vicinity of transistors of any architecture, such as any non-planar or planar architecture. Non-planar transistors such as double-gate transistors, tri-gate transistors, FinFETs, and nanowire/nanoribbon/nanosheet transistors refer to transistors having a non-planar architecture. In comparison to a planar architecture where the transistor channel has only one confinement surface, a non-planar architecture is any type of architecture where the transistor channel has more than one confinement surfaces. A confinement surface refers to a particular orientation of the channel surface that is confined by the gate field. Non-planar transistors potentially improve performance relative to transistors having a planar architecture, such as single-gate transistors. Nanoribbon transistors may be particularly advantageous for continued scaling of complementary metal-oxide-semiconductor (CMOS) technology nodes due to the potential to form gates on all four sides of a channel material (hence, such transistors are sometimes referred to as "gate all around" transistors).

In the example illustrated in FIG. 1A, the device region 104 and the conductive via 102A through the device region 104 are between interconnect layers 103 and 138. Additional interconnect layers may be present above or below the interconnect layers 103 and 138. For example, the IC structure 100A includes the interconnect layer 136 over the interconnect layer 138, and the interconnect layer 108 below the interconnect layer 103. A collection of interconnect layers may be referred to as a "metallization stack" of the IC structure 100A. For example, the metallization stack 119 includes the interconnect layers 103, 108, and the metallization stack 149 includes the interconnect layers 136, 138. Interchangeably, the metallization stacks 119, 149 may be referred to as the "BEOL layer(s)" of the IC structure 100A, while the device region 104 may be referred to as the "FEOL layer(s)" of the IC structure 100A.

Electrical signals, such as power and/or input/output (I/O) signals, may be routed to and/or from the devices 106 (e.g., the transistors) of the device region 104 through one or more interconnect layers disposed on the device region 104 (e.g., illustrated in FIG. 1A as interconnect layers 103, 108, 136, and 138). The interconnect structures 127, 128, 157, and 158 may be arranged within the interconnect layers of the metallization stacks 119, 149 to route electrical signals according to a wide variety of designs (in particular, the arrangement is not limited to the particular configuration of interconnect structures 127, 128, 157, and 158 depicted in FIG. 1A). Although a particular number of interconnect layers 103, 108, 136, 138 is depicted in FIG. 1A, embodiments of the present disclosure include IC structures having more or fewer interconnect layers than depicted.

In some embodiments, the interconnect structures 127, 128, 157, and 158 may include conductive lines 127, 157 and/or conductive vias 128, 158 filled with an electrically conductive material such as a metal. The lines 127, 157 may be arranged to route electrical signals in a direction of a plane that is substantially parallel with the layers 103, 138. For example, the lines 127, 157 may route electrical signals in a direction in and out of the page from the perspective of FIG. 1A. The vias 128, 158 may be arranged to route electrical signals in a direction of a plane that is substantially perpendicular to the layers 103, 138. In some embodiments, the vias 128, 158 may electrically couple lines of different interconnect layers of the corresponding metallization stack together.

The interconnect layers 103, 108, 136, 138 may include a dielectric material disposed between the interconnect structures, as shown in FIG. 1A. For example, the interconnect layers 103, 108 include the dielectric material 126 between the interconnect structures 127, 128, and the interconnect layers 136, 138 include the dielectric material 156 between the interconnect structures 157, 158. In some embodiments, the dielectric material 126 disposed between the interconnect structures 127, 128 in different ones of the interconnect layers 103 and 108 may have different compositions; in other embodiments, the composition of the dielectric material 126 between different interconnect layers 103 and 108 may be the same. Similarly, the composition of the dielectric material 156 between different interconnect layers 136 and 138 may be different or the same. Although not specifically shown in FIG. 1A, in some embodiments, the IC structure 100A may further include a solder resist material (e.g., polyimide or similar material) and one or more conductive contacts formed on the interconnect layers of the metallization stacks 119 and/or 149.

Thus, as illustrated in FIG. 1A, the IC structure 100A includes a layer 103 including a conductive element (e.g., the via 128), a second layer 138 including a conductive element (e.g., the via 158), and a third layer (e.g., one or more layers of the device region 104) including the conductive via 102A between the vias 158 and 128. The conductive via 102A is filled with an electrically conductive material such as a metal (e.g., tungsten or another metal), and electrically couples a conductive element in the layer 103 with a conductive element in the layer 138. Although Figure 1A depicts the conductive via 102A as being between two conductive vias 128, 158, in other examples, the conductive via may be between other conductive elements, such as conductive contacts (e.g., bond pads) or other conductive elements.

Unlike conventional conductive vias that have a V-shape profile or trapezoidal cross-section, the conductive via 102A is wider at both ends than at a portion between the ends of the conductive via 102A. For example, the conductive via 102A includes a first portion 107A having a width 113A, a second portion 111A having a width 117A, and a third portion 109A having a width 115A that is smaller than the widths 113A and 117A, where the width of a given portion of the conductive via 102A is measured in a plane substantially parallel to the layer 103 (e.g., in the x-y plane where the x-axis is shown in FIG. 1A, and the y-axis is in a direction in and out from the page from the perspective of FIG. 1A). In one example, the first portion 107A is closer to the first conductive element 128 than the second portion 111A and is in conductive contact with the first conductive element 128. Similarly, the second portion 111A is closer to the second conductive element 158 than the first portion 107A and is in conductive contact with the second conductive element 158. In the example illustrated in FIG. 1A, the second portion 111A is closer to the devices 106 than the portions 109A and 107A.

In the example illustrated in FIG. 1A, the conductive via 102A tapers from both ends towards a portion between the two ends instead of tapering in one direction like conventional vias. For example, the conductive via tapers from the first portion 107A (e.g., the bottom portion) towards the portion 109A and from a second portion 111A (e.g., the top portion) towards the portion 109A. In one such example, the conductive via can have a cross-section (e.g., a cross-section along the x-z plane as shown in FIG. 1A and substantially perpendicular to the layer 103) that resembles an hourglass shape in the sense that it has a narrower portion between two wider portions. However, the cross-section of double-sided conductive vias may have other shapes or profiles.

The example illustrated in FIG. 1A shows the narrowest portion of the conductive via 102A near the approximate midpoint of the conductive via 102A, where the midpoint of the conductive via 102A between the conductive elements 158, 128 is located 50% of the length 121A of the conductive via 102A from either end of the conductive via 102A. The length 121A of the conductive via 102A is a dimension of the conductive via in a direction substantially perpendicular to the layer 103 (e.g., parallel to the z-axis as shown in FIG. 1A). However, the narrowest portion of the conductive via 102A may not be at or near the mid-point. Additionally, a double-sided conductive via may not have a single "narrowest portion." In one example, a narrowest portion of the conductive via 102A may be located between the midpoint and one end of the conductive via 102A. For example, consider a conductive via such as the conductive via 102A illustrated in FIG. 1A, with a first portion 107A having a first width 113A in a first plane substantially parallel to the layer 103, a second portion 111A having a second width 117A in a second plane substantially parallel to the layer 103, and a third portion 109A having a third width 115A in a third plane substantially parallel to the layer 103. In one such example, the distance between the third plane and the first conductive element 128 is at least 10% of the length 121A and less than 75% of the length 121A of the conductive via 102A. In other examples, the distance between the third plane and the first conductive element 128 is in a range of 25-60% of the length 121A of the conductive via 102A, or 30-55% of the length 121A of the conductive via 102A. In one such example, the third plane is closer to the midpoint of the conductive via 102A than to the conductive element 128 (or closer to the midpoint than to the second conductive element 158).

FIG. 1A depicts the widths 113A, 115A, and 117A as being measured at certain points along the length 121A of the conductive via 102A, however, in other examples, the widths of the portions 107A, 109A, and 111A can be measured at different points than depicted. In one example, the width 113A of the portion 107A can be measured in a plane substantially parallel to the layer 103 at or near an interface between the conductive via 102A and the conductive element 128, or at a nother point of the portion 107A along the length 121A of the conductive via 102A that is closer to the conductive element 128 than to the midpoint of the conductive via 102A along its length 121A. Similarly, in one example, the width 117A of the portion 111A can be measured in a plane substantially parallel to the layer 103 at or near an interface between the conductive via 102A and the conductive element 158, or at another point of the portion 111A along the length 121A of the conductive via 102A that is closer to the conductive element 158 than to the midpoint of the conductive via 102A along its length 121A. The width 115A of the portion 109A can be measured at any point of the portion 109A along the length 121A of the conductive via 102A between the portions 107A, 111A.

In one example, double-sided conductive via can have ends (e.g., a top and bottom) that have substantially the same width, or one end of the conductive via can be wider than the other end. In one example, the width 113A may be about the same as or smaller than the width 114A of the conductive element 128 coupled to the conductive via 102A, where the width 114A is measured in a plane substantially parallel to the layer 103. In one example the width 113A is substantially the same as the width 114A. In one such example, increasing the width 113A to be greater than the width 114A of the conductive element below the conductive via 102A may generally not improve the contact between the conductive via 102A and the conductive element 128. However, in some examples, the width 113A at the portion 107A may be greater than the width 114A of the conductive element 128 (but not so large as to interfere or make unintentional contact with adjacent conductive elements or adjacent devices, such as a subfin of an adjacent nanoribbon transistor). In other examples, the width 113A is smaller than the width 114A (while still being larger than the width 115A).

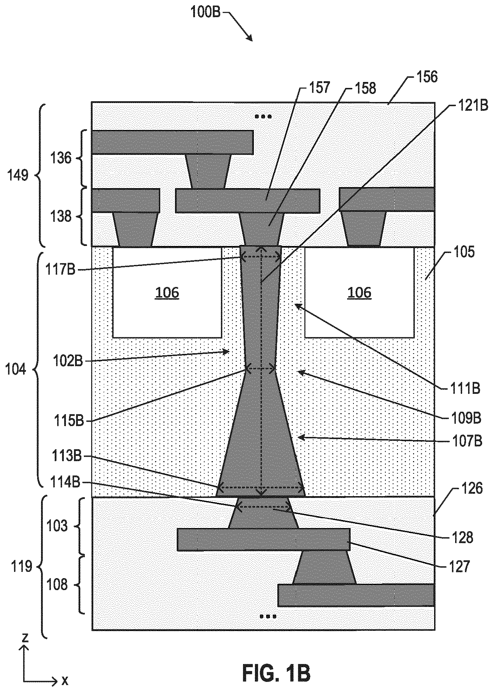

FIG. 1B illustrates an example of an IC structure 100B having a conductive via 102B with one end that is wider than the other. Similar to the conductive via 102A illustrated in FIG. 1A, the conductive via 102B includes a first portion 107B having a width 113B, a second portion 111B having a width 117B, and a third portion 109B having a width 115B that is smaller than the widths 113B and 117B, where the width of a given portion of the conductive via 102B is measured in a plane substantially parallel to the layer 103 (e.g., in the x-y plane where the x-axis is shown in FIG. 1B, and the y-axis is in a direction in and out from the page from the perspective of FIG. 1B). Like the conductive via 102A, the conductive via 102B is between conductive elements 158, 128, and has a length 121B, where the length 121B is a dimension of the conductive via 102B in a direction substantially perpendicular to the layer 103. In addition to the portions 107B and 111B having larger widths than the portion 109B, the portion 107B also has a larger width than the portion 111B. In one example, the width 113B is 5-20% larger than the width 117B. In another example, the width 113B is 10-15% larger than the width 117B. Although FIG. 1B shows the width 113B as being larger than the width 114B of the conductive element 128, the width 113B can be larger than, equal to, or smaller than the width 114B of the conductive element 128.

In some examples, one end of the via may be closer to adjacent devices, and therefore have stricter limits on the maximum width of the portion of the via near the devices to avoid unintentional electrical connection with the adjacent devices. In one such example, the wider end of the conductive via 102B (e.g., the portion 107B) is further from devices 106 than the opposite end of the conductive via 102B (e.g., the portion 111B). In one such example, the wider end (e.g., the portion 107B) is at a back side of the IC structure 100B and the opposite end (e.g., the portion 111B) is at a front side of the IC structure 100B.

Although the schematics in FIGS. 1A and 1B show conductive vias with straight sidewalls, the conductive vias can include one or more substantially straight portions, irregular portions, and/or curved or rounded portions, where even substantially straight portions can include irregularities and/or defects so that they are not perfectly straight. Depending on the processing techniques used to form a conductive via, the conductive via may include one or more curved convex portions. For example, a curved convex portion of a conductive via may be formed due to an isotropic etch process used to open or widen the opening at that end (e.g., via an isotropic wet etch process), which can result in curved convex sidewalls in the etched area. Curved convex sidewalls can result in a bulge or protrusion in the resulting conductive via.

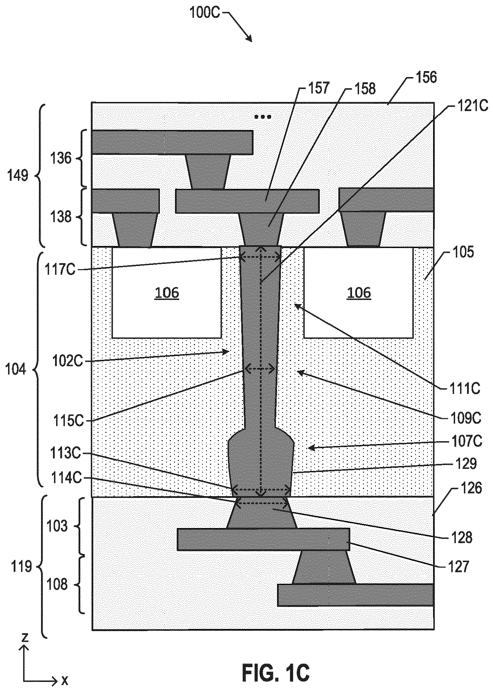

For example, FIG. 1C illustrates an IC structure 100C with a conductive via 102C that includes a curved convex portion 129 proximate to one end of the conductive via 102C. Similar to the conductive vias 102A and 102B illustrated in FIGS. 1A and 1B, the conductive via 102C includes a first portion 107C having a width 113C, a second portion 111C having a width 117C, and a third portion 109C having a width 115C that is smaller than the widths 113C and 117C, where the width of a given portion of the conductive via 102C is measured in a plane substantially parallel to the layer 103 (e.g., in the x-y plane where the x-axis is shown in FIG. 1C, and the y-axis is in a direction in and out from the page from the perspective of FIG. 1C). Like the conductive vias 102A and 102B, the conductive via 102C is between conductive elements 158, 128, and has a length 121C, where the length 121C is a dimension of the conductive via 102C in a direction substantially perpendicular to the layer 103. In one such example, the portion 107C at one end of the conductive via 102C includes a curved convex portion 129 between the conductive element 128 and the portion 109C. In one example, the curved convex portion 129 is closer to the conductive element 128 than to a midpoint of the conductive via 102C along the length 121C of the conductive via 102C. In one example, the end of the conductive via 102C furthest from the devices 106 includes the curved convex portion 129. In one such example, the end of the conductive via 102C with the curved convex portion 129 is at the back side of the IC structure 100C (e.g., closer to the back side of the IC structure than the opposite end). Although FIG. 1C shows the width 113C as being larger than the width 114C of the conductive element 128, the width 113C can be larger than, equal to, or smaller than the width 114C of the conductive element 128.

Thus, FIGS. 1A-1C illustrate examples of conductive vias that can be fabricated with double-sided via processing techniques. Although in the examples illustrated in FIGS. 1A-1C, the device region 104 through which the conductive vias 102A, 102B, and 102C extend is shown as a single layer, the conductive vias 102A, 102B, and 102C can extend through one or multiple layers in a device region or other regions of an IC structure. In the example illustrated in FIGS. 1A-1C, the material surrounding the conductive vias 102A, 102B, and 102C (whether it includes a single layer or multiple layers) lacks a bonding interface or seam. Thus, the conductive vias 102A, 102B, and 102C are each a single via through one or more layers, not multiple vias bonded together (e.g., not different vias formed in or over separate substrates that are bonded together).

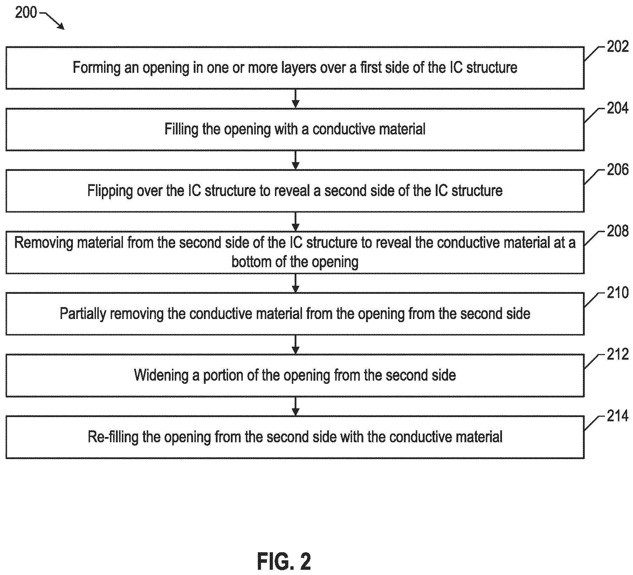

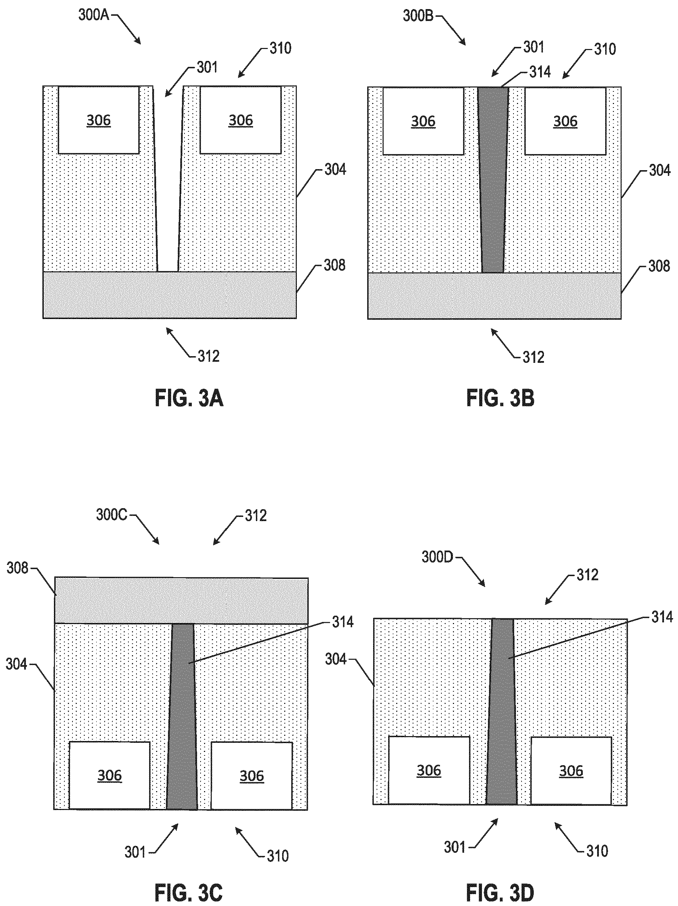

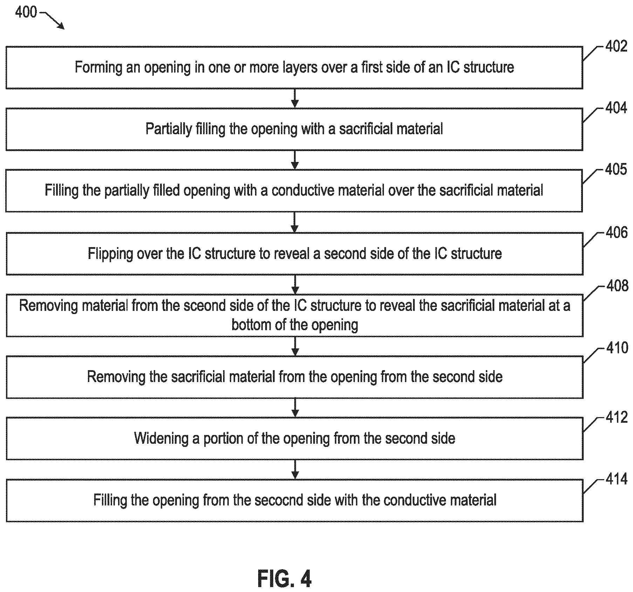

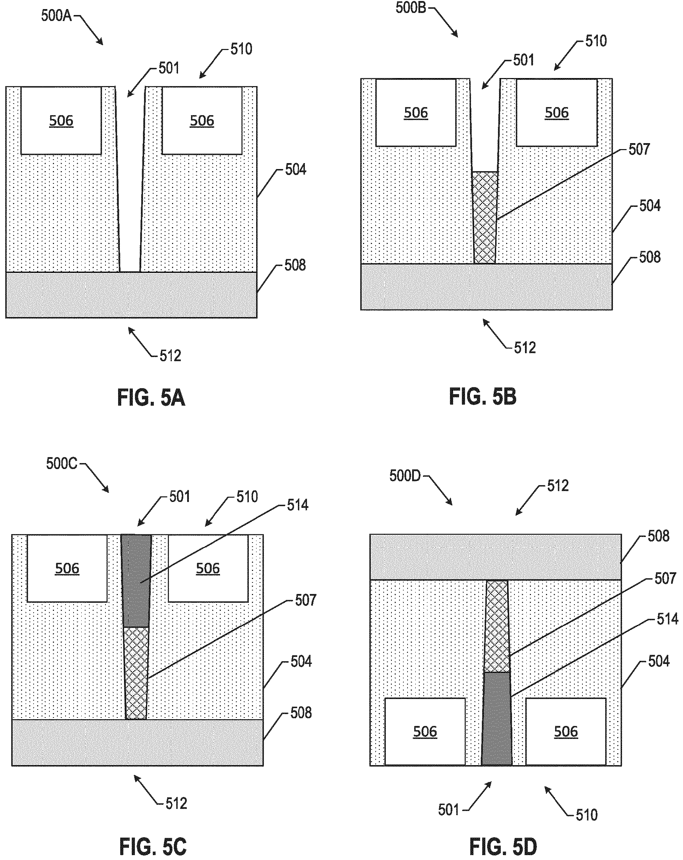

FIGS. 2 and 4 are flow diagrams of example methods for fabricating an IC structure that includes a double-sided conductive via, in accordance with some embodiments. The example methods illustrated in FIGS. 2 and 4 involve forming an opening from a first side and widening a portion of the opening from a second side. FIG. 2 illustrates an example method 200 that involves filling the opening with a conductive material from a first side prior to widening the opening from a second side. FIG. 4 illustrates an example method 400 that involves partially filling the opening with a sacrificial material prior to widening the opening from the second side. FIGS. 3A-3G provide cross-sectional side views at various stages in the fabrication of an example IC structure according to the method of FIG. 2, in accordance with some embodiments. FIGS. 5A-5H provide cross-sectional side views at various stages in the fabrication of an example IC structure according to the method of FIG. 4, in accordance with some embodiments.

Although the operations of the methods of FIGS. 2 and 4 are illustrated once each and in a particular order, the operations may be performed in any suitable order and repeated as desired. For example, one or more operations may be performed in parallel to fabricate multiple IC structures with one or more conductive vias substantially simultaneously. In another example, the operations may be performed in a different order to reflect the structure of an IC device in which a conductive via will be implemented.

In addition, the example fabricating methods of FIGS. 2 and 4 may include other operations not specifically shown in FIGS. 2 and 4, such as various cleaning or planarization operations as known in the art. For example, in some embodiments, a support, as well as layers of various other materials subsequently deposited thereon, may be cleaned prior to, after, or during any of the processes of the methods described herein, e.g., to remove oxides, surface-bound organic and metallic contaminants, as well as subsurface contamination. In some embodiments, cleaning may be carried out using e.g., a chemical solution (such as peroxide), and/or with ultraviolet (UV) radiation combined with ozone, and/or oxidizing the surface (e.g., using thermal oxidation) then removing the oxide (e.g., using hydrofluoric acid (HF)). In another example, the intermediate IC structures described herein may be planarized prior to, after, or during any of the processes of the methods of FIGS. 2 and 4 described herein, e.g., to remove overburden or excess materials. In some embodiments, planarization may be carried out using either wet or dry planarization processes, e.g., planarization be a chemical mechanical planarization (CMP), which may be understood as a process that utilizes a polishing surface, an abrasive and a slurry to remove the overburden and planarize the surface.

Turning to FIG. 2, the method 200 begins with a process 202 of forming an opening in one or more layers over a first side of the IC structure. An IC structure 300A of FIG. 3A illustrates an example result of the process 202. The IC structure 300A includes a support 308, an insulator material 304, devices 306, and an opening 301 in the insulator material 304.

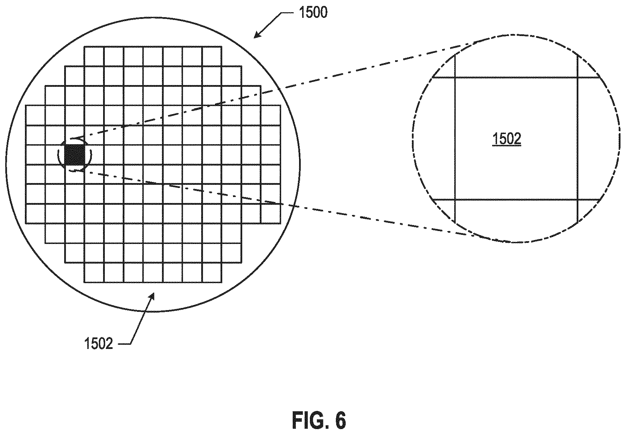

The support 308 can be, for example, a substrate, a die, a wafer, or a chip. The support 308 may, e.g., be the wafer 1500 of FIG. 6, discussed below, and may be, or be included in, a die, e.g., the singulated die 1502 of FIG. 6, discussed below. The support 308 may be a semiconductor substrate composed of semiconductor material systems including, for example, N-type or P-type materials systems. In one implementation, the semiconductor substrate may be a crystalline substrate formed using a bulk silicon or a silicon-on-insulator (SOI) substructure. In other implementations, the semiconductor substrate may be formed using alternate materials, which may or may not be combined with silicon, that include, but are not limited to, germanium, silicon germanium, indium antimonide, lead telluride, indium arsenide, indium phosphide, gallium arsenide, aluminum gallium arsenide, aluminum arsenide, indium aluminum arsenide, aluminum indium antimonide, indium gallium arsenide, gallium nitride, indium gallium nitride, aluminum indium nitride or gallium antimonide, or other combinations of group III-V materials (i.e., materials from groups III and V of the periodic system of elements), group II-VI (i.e., materials from groups II and IV of the periodic system of elements), or group IV materials (i.e., materials from group IV of the periodic system of elements). In some embodiments, the substrate may be non-crystalline. In some embodiments, the support 308 may be a printed circuit board (PCB) substrate, a package substrate, an interposer, a wafer, or a die. Although a few examples of materials from which the support 308 may be formed are described here, any material that may serve as a foundation upon which an IC structure including double-sided vias as described herein may be built falls within the spirit and scope of the present disclosure.

The insulator material 304 may include any suitable insulator material, e.g., one or more materials described above with reference to the ILD materials. The devices 306 can include transistors and/or other devices, as discussed above with respect to the devices 106 of FIGS. 1A-1C. In one example, the opening 301 is a trench (e.g., via trench or deep trench). The opening 301 is formed from a first side 310 that is opposite a second side 312. In one example, the first side 310 is the front side (e.g., front side of the IC structure 300A or front side of a support over which the IC structure is fabricated), and the second side 312 is the back side (e.g., back side of the IC structure 300A or back side of a support over which the IC structure is fabricated). Any suitable etching technique, e.g., a dry etch, such as e.g., radio frequency (RF) reactive ion etch (RIE) or inductively coupled plasma (ICP) RIE may be used for forming the opening 301. In some embodiments, the etch performed in the process 202 may include an anisotropic etch, using etchants in a form of e.g., chemically active ionized gas (i.e., plasma) using e.g., bromine (Br) and chloride (CI) based chemistries. In some embodiments, during the etch of the process 202, the IC structure may be heated to elevated temperatures, e.g., to temperatures between about room temperature and 200 degrees Celsius, including all values and ranges therein, to promote that byproducts of the etch are made sufficiently volatile to be removed from the surface.

Referring again to FIG. 2, the method 200 may then proceed with a process 204, in which the opening is filled with a conductive material. An IC structure 300B of FIG. 3B illustrates an example result of the process 204. The IC structure 300B includes the opening 301 filled with the conductive material 314. The electrically conductive material 314 may include any suitable electrically conductive material, such as any of those described above, and may be deposited in the process 204 using a technique such as atomic layer deposition (ALD), chemical vapor deposition (CVD), plasma enhanced CVD (PECVD), or/and physical vapor deposition (PVD) processes such as sputter.

The method 200 may then proceed with a process 206, in which the IC structure is flipped over to reveal a second side of the IC structure. An IC structure 300C of FIG. 3C illustrates an example result of the process 206. Specifically, the IC structure 300C is the same as the IC structure 300B, but flipped over to enable processing from the second side 312 of the IC structure 300C. As mentioned above, in one example, the second side 312 may be referred to as the back side of the IC structure 300C or the back side of the support 308.

Referring again to FIG. 2, the method 200 may then proceed with a process 208, in which material from the second side of the IC structure is removed to reveal the conductive material at a bottom of the opening. An IC structure 300D of FIG. 3D illustrates an example result of the process 208. Specifically, the support 308 (or at least a portion of the support 308 over the opening 301) has been removed from the second side of the IC structure 300D. The support 308 may be removed in the process 208 using a suitable thinning/polishing process. After removing the support 308, the conductive material 314 is revealed at one end of the opening 301 (e.g., at the bottom of the opening 301).

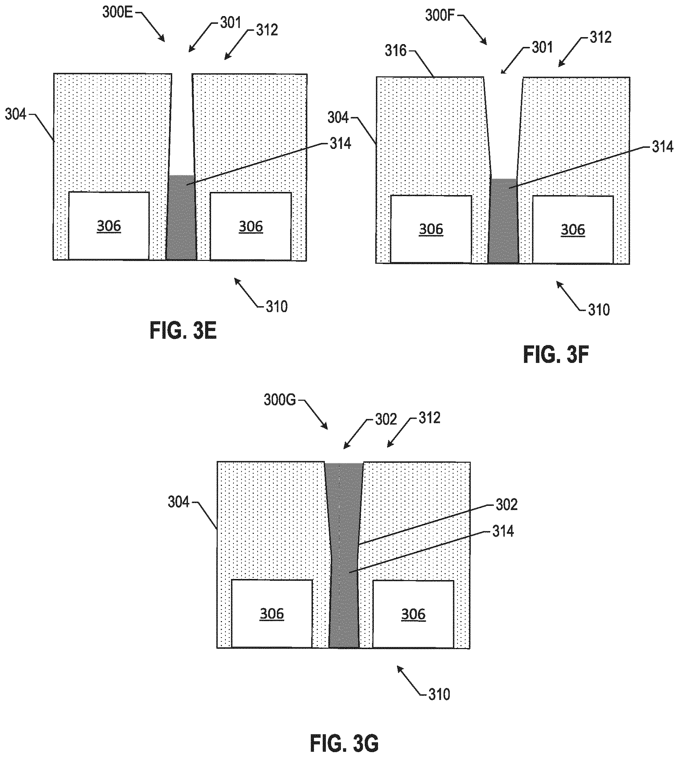

Referring again to FIG. 2, the method 200 may then proceed with a process 210, in which the conductive material is partially removed from the opening (e.g., recessed) from the second side of the IC structure. An IC structure 300E of FIG. 3E illustrates an example result of the process 210. Any suitable etching technique, such as the techniques described above with respect to process 202, may be used to recess the conductive material 314 in the opening 301. In one example, partially removing the conductive material exposes side walls at the bottom of the opening 301 (e.g., side walls of the opening 301 proximate to the second side 312). The extent to which the conductive material 314 is recessed can depend on a number of factors, such as minimizing the shorting risk to neighboring devices, and may be, for example, between 5-75% of the length of the opening 301, where the length of the opening 301 is a dimension of the opening 301 in a direction substantially perpendicular to the support 308. In one example, the conductive material 314 is removed from a portion of the opening 301 extending from the bottom to 25-60%, or from the bottom to 30-55% of the length of the opening, where in this example, the bottom refers to the side of the opening proximate to the second side 312. In one example, the conductive material 314 is recessed to the point where the opening 301 begins to taper or the point at which the tapering increases. In one example, the extent to which the conductive material 314 is recessed in the opening affects what percentage of the opening 301 will be widened in a subsequent process. Thus, in one example, the conductive material 314 is recessed to a point that is sufficient to enable increasing the minimum width of the opening 301 with a subsequent process, but not so far as to not interfere with or result in unintentional contact with the adjacent devices 306. In one such example, the conductive material 314 is recessed from the bottom of the opening 301 to a point before or near the adjacent devices 306.

Referring again to FIG. 2, the method 200 may then proceed with a process 212, in which a portion of the opening is widened from the second side. An IC structure 300F of FIG. 3F illustrates an example result of the process 212. Any suitable etching technique, such as the techniques described above, may be used to widen a portion of the opening 301. For example, widening a portion of the opening may involve wet etching or dry etching sidewalls of the opening exposed by partially removing the conductive material. In one example, a wet etch process that is selective to the conductive material 314 is used to etch the insulator material 304 on the sidewalls of the opening 301.

In various examples, a material may or may not be deposited on the top surface 316 (e.g., the surface of the second side 312) of the insulator material 304 prior to widening the portion of the opening 301 to prevent removal of the insulator material 304 from areas other than the sidewalls of the opening 301. In one example, a material such as Titanium Nitride (TiN) or other hard mask material may be deposited over the surface 316 of the insulator material 304. In one such example, the hard mask material is removed from the sidewalls of the opening 301 (e.g., with a dry etch process or other processing technique to remove the hard mask material from the sidewalls) prior to widening the opening 301. Thus, in some examples, loss of the insulator material 304 from the surface 316 is prevented without additional lithography and masking processes. In other examples, a portion of the opening 301 is widened without protecting the surrounding insulator material 304, which may result in some loss of the insulator material 304 from the surface 316.

Different embodiments can vary regarding the extent to which the portion of the opening is widened from the second side 312. For example, the opening 301 can be widened from the second side 312 to form a conductive via that has substantially the same width at both ends. In another example, the opening 301 can be widened from the second side 312 to be wider than or narrower than the opposite end (e.g., the end of the via proximate to the first side 310). In some examples, widening the opening 301 from the second side 312 enables even wider dimensions than can be achieved when patterning from the first side 310 due to the proximity of devices 306 on the first side 310. Thus, in one such example, the opening 301 can be widened from the second side 312 to have a significantly wider portion at the end proximate to the second side 312 (similar to the conductive via 102B of FIG. 1B). Depending on the processing techniques used, the shape of the opening 301 may have a curved or rounded profile at the widened portion proximate to the second side 312 (similar to the conductive via 102C of FIG. 1C), substantially straight sidewalls (similar to the conductive via 102A of FIG. 1A), or other shape or profile.

Referring again to FIG. 2, the method 200 may then proceed with a process 214, in which the opening is re-filled with the conductive material from the second side. An IC structure 300G of FIG. 3G illustrates an example result of the process 214. The partially filled opening 301 may be filled with the conductive material 314 using any suitable process, such as the techniques described above with respect to the process 204. The resulting conductive via 302 of the IC structure 300G has a larger width at the second side 312 than conventional vias, resulting in reduced resistance and improved performance. The IC structure 300G can then undergo additional processing, for example, to form metallization layers over the first and/or second sides of the IC structure 300G to electrically connect the conductive via 302 to other conductive elements and/or devices.

Turning now to FIG. 4, the method 400 is a flow diagram of another method for fabricating an IC structure with a double-sided via in which the via opening is partially filed with a sacrificial material before metal deposition. The method 400 begins with a process 402 of forming an opening in one or more layers over a first side of the IC structure. An IC structure 500A of FIG. 5A illustrates an example result of the process 402. The IC structure 500A includes a support 508, an insulator material 504, devices 506, and an opening 501 in the insulator material 504. The support 508, insulator material 504, and devices 506 can be the same as or similar to the support 308, insulator material 304, and devices 306 of FIG. 3A, described above. The opening 501 can be a trench (e.g., via trench or deep trench) that is formed from a first side 510 that is opposite a second side 512. In one example, the first side 510 is the front side (e.g., front side of the IC structure 500A or front side of a support over which the IC structure is fabricated), and the second side 512 is the back side (e.g., back side of the IC structure 500A or back side of a support over which the IC structure is fabricated). Any suitable etching technique may be used for forming the opening 501, such as the techniques described above with reference to the process 202.

The method 400 may then proceed with a process 404, in which the opening is partially filled with a sacrificial material. An IC structure 500B of FIG. 5B illustrates an example result of the process 404. The IC structure 500B includes the opening 501 partially filled with the sacrificial material 507. The sacrificial material may be any suitable sacrificial material, such as a carbon-based material (e.g., a carbon-based photoresist) or other sacrificial material, and may be deposited in the process 404 using any suitable processing technique, such as those described above with respect to the process 204. In one example, the extent to which the opening 501 is filled depends on the portion of the opening 501 to be widened from the second side 512. For example, the opening 501 can be filled between 5-75% of the length of the opening 501, where the length of the opening 501 is a dimension of the opening 501 in a direction substantially perpendicular to the support 508. In one example, the opening 501 is filled to 25-60% or 30-55% of the length of the opening 501. In one example, the opening 501 is filled up to the point where the opening 501 begins to taper or the point at which the tapering increases. In one example, the extent to which the opening 501 is filled affects what percentage of the opening 301 will be widened in a subsequent process. Thus, in one example, the opening 501 is filled to a point that is sufficient to enable increasing the minimum width of the opening 501 with a subsequent process, but not so much as to not interfere with or result in unintentional contact with the adjacent devices 506. In one such example, the opening 501 is filled to a point below or near the adjacent devices 506.

The method 400 may then proceed with a process 405, in which the partially filled opening is filled with a conductive material over the sacrificial material. An IC structure 500C of FIG. 5C illustrates an example result of the process 405. The electrically conductive material 514 may include any suitable electrically conductive material, such as any of those described above, and may be deposited in the process 405 using any suitable processing technique, such as those described above with respect to the process 204.

The method 400 may then proceed with a process 406, in which the IC structure is flipped over to reveal a second side of the IC structure. An IC structure 500D of FIG. 5D illustrates an example result of the process 406. Specifically, the IC structure 500D is the same as the IC structure 500C but flipped over to enable processing the second side 512 of the IC structure 500D.

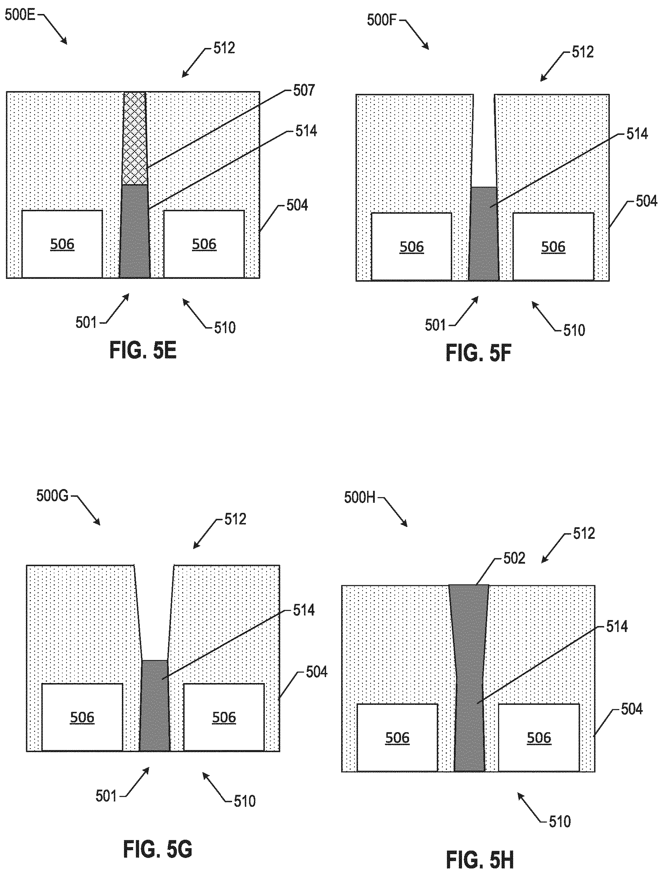

Referring again to FIG. 4, the method 400 may then proceed with a process 408, in which material from the second side of the IC structure is removed to reveal the sacrificial material at a bottom of the opening. An IC structure 500E of FIG. 5E illustrates an example result of the process 408. Specifically, the support 508 (or at least a portion of the support 508 over the opening 501) has been removed from the second side 512 of the IC structure 500E. The support 508 may be removed in the process 408 using a suitable thinning/polishing process. After removing the support 508, the sacrificial material 507 is revealed at one end of the opening 501 (e.g., at the bottom of the opening 501).

Referring again to FIG. 4, the method 400 may then proceed with a process 410, in which the sacrificial material is removed from the opening from the second side of the IC structure. An IC structure 500F of FIG. 5F illustrates an example result of the process 410. Any suitable technique may be used to remove the sacrificial material, such as ashing or an etching technique, such as the techniques described above with respect to process 202. In one example, removing the sacrificial material exposes side walls at the bottom of the opening 501 (e.g., at an end of the opening 501 proximate to the second side 512).

Referring again to FIG. 4, the method 400 may then proceed with a process 412, in which a portion of the opening is widened from the second side. An IC structure 500G of FIG. 5G illustrates an example result of the process 412. Widening the portion of the opening 501 may involve the same or similar techniques as described above with respect to the process 212 of FIG. 2 (e.g., any suitable etching technique, such as the techniques described above, may be used to widen a portion of the opening 501). For example, widening a portion of the opening 501 may involve wet etching or dry etching sidewalls of the opening 501 exposed by removing the sacrificial material. The exposed surfaces of the insulator material 504 other than the exposed sidewalls of the opening 501 may be protected (e.g., with a hard mask material as described above) or left exposed prior to widening the opening 501. Also, depending on the processing techniques used, the shape of the opening 501 after widening may have a curved or rounded profile at the widened portion proximate to the second side 512 (similar to the conductive via 102C of FIG. 1C), substantially straight sidewalls (similar to the conductive via 102A of FIG. 1A and the conductive via 102B of FIG. 1B), or another shape or profile.

Referring again to FIG. 4, the method 400 may then proceed with a process 414, in which the opening is filled with the conductive material from the second side. An IC structure 500H of FIG. 5H illustrates an example result of the process 414. The opening 501 may be filled with the conductive material 514 using any suitable process, such as the techniques described above with respect to the process 204. The resulting conductive via 502 of the IC structure 500H has a larger width at the second side 512 than conventional vias, resulting in reduced resistance and improved performance. The IC structure 500H can then undergo additional processing, for example, to form metallization layers over the first and/or second sides of the IC structure 500H to electrically connect the conductive via 502 to other conductive elements and/or devices.

Thus, the method 400 is another method for fabricating an IC structure with a double-sided via in which a sacrificial material is used. In one example, the sacrificial material can then be removed (e.g., ashed away) post-backside polish to reveal the portion of the via opening to be widened. Using a sacrificial material can eliminate complications associated with recessing the conductive material (such as in the method 200 of FIG. 2).

Performing the methods 200 or 400 may result in several features in the final IC structures that are characteristic of the use of the methods 200 and 400. For example, one such feature is illustrated in the IC structure 100A shown in FIG. 1A, in which the width 115A of the portion 109A is smaller than the widths 113A and 117A of the portions 107A and 111A, respectively. In another example, the width of the conductive via at the end further from adjacent devices may be wider than the end closer to the adjacent devices. For example, the IC structure 100B shown in FIG. 1B has a width 113B of the portion 107B that is wider than the width 117B of the portion 111B. In another example, the conductive via may have a curved convex portion proximate to the end further from adjacent devices. For example, the IC structure 100C shown in FIG. 1C has a curved convex portion 129. Regardless of the exact widths or shapes, the conductive vias that are first formed from one side of an IC structure and then widened from the opposite side can have wider dimensions than conventional vias, which can result in reduced resistance and improved performance.

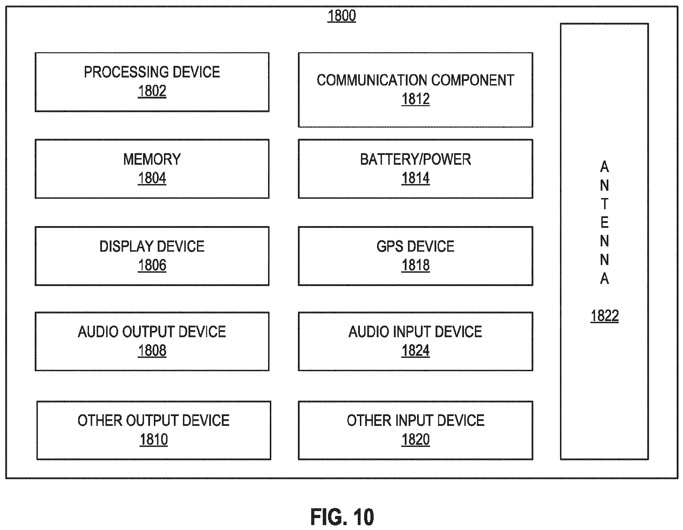

FIG. 6 is a top view of a wafer 1500 and dies 1502 that may include one or more IC structures with a conductive via in accordance with any of the embodiments disclosed herein. The wafer 1500 may be composed of semiconductor material and may include one or more dies 1502 having IC structures formed on a surface of the wafer 1500. Each of the dies 1502 may be a repeating unit of a semiconductor product that includes any suitable IC. After the fabrication of the semiconductor product is complete, the wafer 1500 may undergo a singulation process in which the dies 1502 are separated from one another to provide discrete "chips" of the semiconductor product. The die 1502 may include one or more of the IC structures 100A, 100B, and/or 100C of FIGS. 1A-1C, any of the IC structures shown in FIGS. 3E-3G or FIGS. 5E-5H, or any combination of such IC structures, and/or supporting circuitry to route electrical signals to the transistors of these IC structures, as well as any other IC components. In some embodiments, the wafer 1500 or the die 1502 may include a memory device (e.g., a random-access memory (RAM) device, such as a static RAM (SRAM) device, a magnetic RAM (MRAM) device, a resistive RAM (RRAM) device, a conductive-bridging RAM (CBRAM) device, etc.), a logic device (e.g., an AND, OR, NAND, or NOR gate), or any other suitable circuit element. Multiple ones of these devices may be combined on a single die 1502. For example, a memory array formed by multiple memory devices may be formed on a same die 1502 as a processing device (e.g., the processing device 1802 of FIG. 10) or other logic that is configured to store information in the memory devices or execute instructions stored in the memory array.

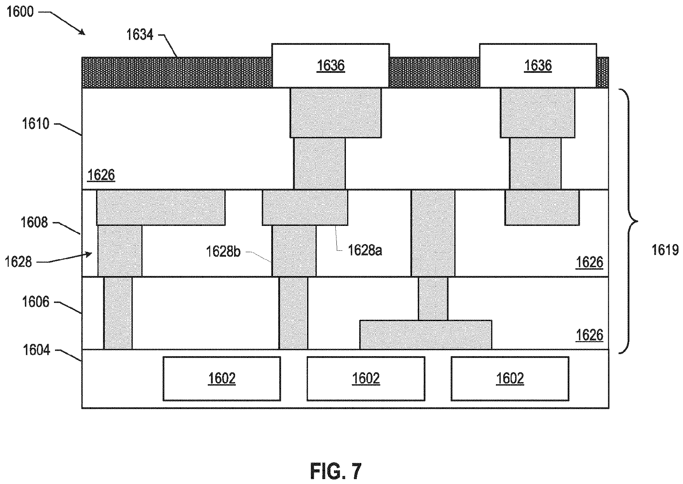

FIG. 7 is a side, cross-sectional view of an IC device 1600 that may include one or more IC structures with a conductive via in accordance with any of the embodiments disclosed herein. One or more of the IC devices 1600 may be included in one or more dies 1502. The IC device 1600 may include a device region 1604 including one or more IC structures 1602, where any of the IC structures 1602 may include any of the IC structures with a conductive via in accordance with examples disclosed herein, e.g., one or more of the IC structures 100A, 100B, and/or 100C of FIGS. 1A-1C, any of the IC structures shown in FIGS. 3E-3G or FIGS. 5E-5H or any combination of such IC structures. The device region 1604 may further include electrical contacts to the gate and S/D contacts of the transistors included in the device region 1604.

Electrical signals, such as power and/or input/output (I/O) signals, may be routed to and/or from the devices (e.g., the transistors) of the device region 1604 through one or more interconnect layers disposed on the device region 1604 (illustrated in FIG. 7 as interconnect layers 1606, 1608, and 1610). For example, electrically conductive features of the device region 1604 (e.g., the gate electrode materials, the electrically conductive materials, and the electrically conductive materials of the IC structures 1602) may be electrically coupled with the interconnect structures 1628 of the interconnect layers 1606, 1608, and 1610. The one or more interconnect layers 1606, 1608, and 1610 may form a metallization stack (also referred to as an "ILD stack") 1619 of the IC device 1600.

The interconnect structures 1628 may be arranged within the interconnect layers 1606, 1608, and 1610 to route electrical signals according to a wide variety of designs (in particular, the arrangement is not limited to the particular configuration of interconnect structures 1628 depicted in FIG. 7). Although a particular number of interconnect layers 1606, 1608, and 1610 is depicted in FIG. 7, embodiments of the present disclosure include IC structures having more or fewer interconnect layers than depicted.

In some embodiments, the interconnect structures 1628 may include lines 1628a and/or vias 1628b filled with an electrically conductive material such as a metal. One or more of the vias 1628b can include double-sided vias in accordance with examples described herein. The lines 1628a may be arranged to route electrical signals in a direction of a plane that is substantially parallel with a surface of the support upon which the device region 1604 is formed. For example, the lines 1628a may route electrical signals in a direction in and out of the page from the perspective of FIG. 7. The vias 1628b may be arranged to route electrical signals in a direction of a plane that is substantially perpendicular to the surface of the support upon which the device region 1604 is formed. In some embodiments, the vias 1628b may electrically couple lines 1628a of different interconnect layers 1606, 1608, and 1610 together.

The interconnect layers 1606, 1608, and 1610 may include a dielectric material 1626 disposed between the interconnect structures 1628, as shown in FIG. 7. In some embodiments, the dielectric material 1626 disposed between the interconnect structures 1628 in different ones of the interconnect layers 1606, 1608, and 1610 may have different compositions; in other embodiments, the composition of the dielectric material 1626 between different interconnect layers 1606, 1608, and 1610 may be the same.

A first interconnect layer 1606 may be formed above the device region 1604. In some embodiments, the first interconnect layer 1606 may include lines 1628a and/or vias 1628b, as shown. The lines 1628a of the first interconnect layer 1606 may be coupled with contacts of the device region 1604.

A second interconnect layer 1608 may be formed above the first interconnect layer 1606. In some embodiments, the second interconnect layer 1608 may include vias 1628b to couple the lines 1628a of the second interconnect layer 1608 with the lines 1628a of the first interconnect layer 1606. Although the lines 1628a and the vias 1628b are structurally delineated with a line within each interconnect layer (e.g., within the second interconnect layer 1608) for the sake of clarity, the lines 1628a and the vias 1628b may be structurally and/or materially contiguous (e.g., simultaneously filled during a dual-damascene process) in some embodiments.

A third interconnect layer 1610 (and additional interconnect layers, as desired) may be formed in succession on the second interconnect layer 1608 according to similar techniques and configurations described in connection with the second interconnect layer 1608 or the first interconnect layer 1606. In some embodiments, the interconnect layers that are "higher up" in the metallization stack 1619 in the IC device 1600 (i.e., farther away from the device region 1604) may be thicker.

The IC device 1600 may include a solder resist material 1634 (e.g., polyimide or similar material) and one or more conductive contacts 1636 formed on the interconnect layers 1606, 1608, and 1610. In FIG. 7, the conductive contacts 1636 are illustrated as taking the form of bond pads. The conductive contacts 1636 may be electrically coupled with the interconnect structures 1628 and configured to route the electrical signals of the transistor(s) of the device region 1604 to other external devices. For example, solder bonds may be formed on the one or more conductive contacts 1636 to mechanically and/or electrically couple a chip including the IC device 1600 with another component (e.g., a circuit board). The IC device 1600 may include additional or alternate structures to route the electrical signals from the interconnect layers 1606, 1608, and 1610; for example, the conductive contacts 1636 may include other analogous features (e.g., posts) that route the electrical signals to external components.

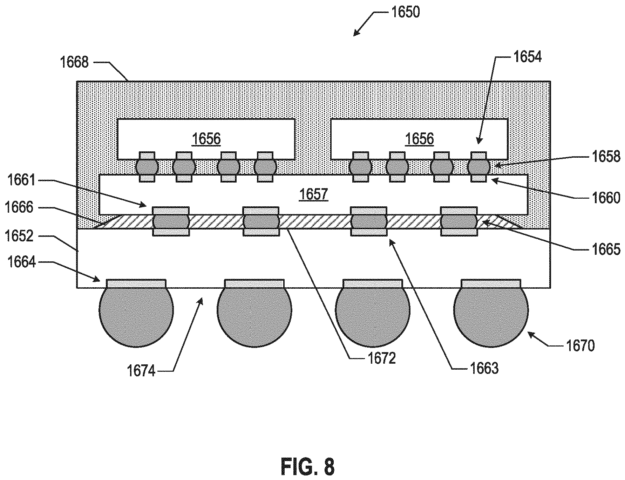

FIG. 8 is a side, cross-sectional view of an example IC package 1650 that may include one or more IC structures with a conductive via in accordance with any of the embodiments disclosed herein. In some embodiments, the IC package 1650 may be a system-in-package (SiP).

The package substrate 1652 may be formed of a dielectric material (e.g., a ceramic, a buildup film, an epoxy film having filler particles therein, glass, an organic material, an inorganic material, combinations of organic and inorganic materials, embedded portions formed of different materials, etc.), and may have conductive pathways extending through the dielectric material between the face 1672 and the face 1674, or between different locations on the face 1672, and/or between different locations on the face 1674. These conductive pathways may take the form of any of the interconnects 1628 discussed above with reference to FIG. 7.

The package substrate 1652 may include conductive contacts 1663 that are coupled to conductive pathways (not shown) through the package substrate 1652, allowing circuitry within the dies 1656 and/or the interposer 1657 to electrically couple to various ones of the conductive contacts 1664 (or to devices included in the package substrate 1652, not shown).

The IC package 1650 may include an interposer 1657 coupled to the package substrate 1652 via conductive contacts 1661 of the interposer 1657, first-level interconnects 1665, and the conductive contacts 1663 of the package substrate 1652. The first-level interconnects 1665 illustrated in FIG. 8 are solder bumps, but any suitable first-level interconnects 1665 may be used. In some embodiments, no interposer 1657 may be included in the IC package 1650; instead, the dies 1656 may be coupled directly to the conductive contacts 1663 at the face 1672 by first-level interconnects 1665. More generally, one or more dies 1656 may be coupled to the package substrate 1652 via any suitable structure (e.g., a silicon bridge, an organic bridge, one or more waveguides, one or more interposers, wirebonds, etc.).

The IC package 1650 may include one or more dies 1656 coupled to the interposer 1657 via conductive contacts 1654 of the dies 1656, first-level interconnects 1658, and conductive contacts 1660 of the interposer 1657. The conductive contacts 1660 may be coupled to conductive pathways (not shown) through the interposer 1657, allowing circuitry within the dies 1656 to electrically couple to various ones of the conductive contacts 1661 (or to other devices included in the interposer 1657, not shown). The first-level interconnects 1658 illustrated in FIG. 8 are solder bumps, but any suitable first-level interconnects 1658 may be used. As used herein, a "conductive contact" may refer to a portion of conductive material (e.g., metal) serving as an interface between different components; conductive contacts may be recessed in, flush with, or extending away from a surface of a component, and may take any suitable form (e.g., a conductive pad or socket).

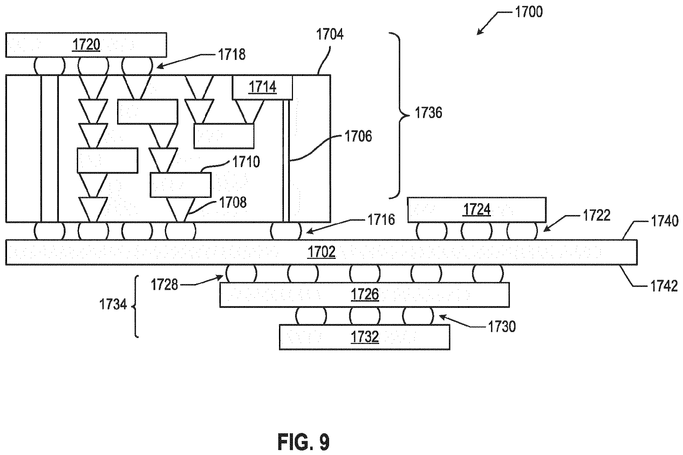

In some embodiments, an underfill material 1666 may be disposed between the package substrate 1652 and the interposer 1657 around the first-level interconnects 1665, and a mold compound 1668 may be disposed around the dies 1656 and the interposer 1657 and in contact with the package substrate 1652. In some embodiments, the underfill material 1666 may be the same as the mold compound 1668. Example materials that may be used for the underfill material 1666 and the mold compound 1668 are epoxy mold materials, as suitable. Second-level interconnects 1670 may be coupled to the conductive contacts 1664. The second-level interconnects 1670 illustrated in FIG. 8 are solder balls (e.g., for a ball grid array arrangement), but any suitable second-level interconnects 1670 may be used (e.g., pins in a pin grid array arrangement or lands in a land grid array arrangement). The second-level interconnects 1670 may be used to couple the IC package 1650 to another component, such as a circuit board (e.g., a motherboard), an interposer, or another IC package, as known in the art and as discussed below with reference to FIG. 9.

The dies 1656 may take the form of any of the embodiments of the die 1502 discussed herein (e.g., may include any of the embodiments of the IC device 1600). In embodiments in which the IC package 1650 includes multiple dies 1656, the IC package 1650 may be referred to as a multichip package (MCP). The dies 1656 may include circuitry to perform any desired functionality. For example, or more of the dies 1656 may be logic dies (e.g., silicon-based dies), and one or more of the dies 1656 may be memory dies (e.g., high-bandwidth memory).

Although the IC package 1650 illustrated in FIG. 8 is a flip chip package, other package architectures may be used. For example, the IC package 1650 may be a ball grid array (BGA) package, such as an embedded wafer-level ball grid array (eWLB) package. In another example, the IC package 1650 may be a wafer-level chip scale package (WLCSP) or a panel fanout (FO) package. Although two dies 1656 are illustrated in the IC package 1650 of FIG. 8, an IC package 1650 may include any desired number of dies 1656. An IC package 1650 may include additional passive components, such as surface-mount resistors, capacitors, and inductors disposed on the first face 1672 or the second face 1674 of the package substrate 1652, or on either face of the interposer 1657. More generally, an IC package 1650 may include any other active or passive components known in the art.

FIG. 9 is a side, cross-sectional view of an IC device assembly 1700 that may include one or more IC packages or other electronic components (e.g., a die) including one or more IC structures with a conductive via in accordance with any of the embodiments disclosed herein. The IC device assembly 1700 includes a number of components disposed on a circuit board 1702 (which may be, e.g., a motherboard). The IC device assembly 1700 includes components disposed on a first face 1740 of the circuit board 1702 and an opposing second face 1742 of the circuit board 1702; generally, components may be disposed on one or both faces 1740 and 1742. Any of the IC packages discussed below with reference to the IC device assembly 1700 may take the form of any of the embodiments of the IC package 1650 discussed above with reference to FIG. 7 (e.g., may include one or more IC structures with a conductive via in accordance with examples described herein).

In some embodiments, the circuit board 1702 may be a PCB including multiple metal layers separated from one another by layers of dielectric material and interconnected by electrically conductive vias. Any one or more of the metal layers may be formed in a desired circuit pattern to route electrical signals (optionally in conjunction with other metal layers) between the components coupled to the circuit board 1702. In other embodiments, the circuit board 1702 may be a non-PCB substrate.

The IC device assembly 1700 illustrated in FIG. 9 includes a package-on-interposer structure 1736 coupled to the first face 1740 of the circuit board 1702 by coupling components 1716. The coupling components 1716 may electrically and mechanically couple the package-on-interposer structure 1736 to the circuit board 1702, and may include solder balls (as shown in FIG. 9), male and female portions of a socket, an adhesive, an underfill material, and/or any other suitable electrical and/or mechanical coupling structure.

The package-on-interposer structure 1736 may include an IC package 1720 coupled to a package interposer 1704 by coupling components 1718. The coupling components 1718 may take any suitable form for the application, such as the forms discussed above with reference to the coupling components 1716. Although a single IC package 1720 is shown in FIG. 9, multiple IC packages may be coupled to the package interposer 1704; indeed, additional interposers may be coupled to the package interposer 1704. The package interposer 1704 may provide an intervening substrate used to bridge the circuit board 1702 and the IC package 1720. The IC package 1720 may be or include, for example, a die (the die 1502 of FIG. 6), an IC device (e.g., the IC device 1600 of FIG. 7), or any other suitable component. Generally, the package interposer 1704 may spread a connection to a wider pitch or reroute a connection to a different connection. For example, the package interposer 1704 may couple the IC package 1720 (e.g., a die) to a set of BGA conductive contacts of the coupling components 1716 for coupling to the circuit board 1702. In the embodiment illustrated in FIG. 9, the IC package 1720 and the circuit board 1702 are attached to opposing sides of the package interposer 1704; in other embodiments, the IC package 1720 and the circuit board 1702 may be attached to a same side of the package interposer 1704. In some embodiments, three or more components may be interconnected by way of the package interposer 1704.

In some embodiments, the package interposer 1704 may be formed as a PCB, including multiple metal layers separated from one another by layers of dielectric material and interconnected by electrically conductive vias. In some embodiments, the package interposer 1704 may be formed of an epoxy resin, a fiberglass-reinforced epoxy resin, an epoxy resin with inorganic fillers, a ceramic material, or a polymer material such as polyimide. In some embodiments, the package interposer 1704 may be formed of alternate rigid or flexible materials that may include the same materials described above for use in a semiconductor substrate, such as silicon, germanium, and other group III-V and group IV materials. The package interposer 1704 may include metal lines 1710 and vias 1708, including but not limited to through-silicon vias (TSVs) 1706. The vias 1706 and 1708 may be in accordance with examples described herein. The package interposer 1704 may further include embedded devices 1714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as RF devices, power amplifiers, power management devices, antennas, arrays, sensors, and microelectromechanical systems (MEMS) devices may also be formed on the package interposer 1704. The package-on-interposer structure 1736 may take the form of any of the package-on-interposer structures known in the art.

The IC device assembly 1700 may include an IC package 1724 coupled to the first face 1740 of the circuit board 1702 by coupling components 1722. The coupling components 1722 may take the form of any of the embodiments discussed above with reference to the coupling components 1716, and the IC package 1724 may take the form of any of the embodiments discussed above with reference to the IC package 1720.

The IC device assembly 1700 illustrated in FIG. 9 includes a package-on-package structure 1734 coupled to the second face 1742 of the circuit board 1702 by coupling components 1728. The package-on-package structure 1734 may include an IC package 1726 and an IC package 1732 coupled together by coupling components 1730 such that the IC package 1726 is disposed between the circuit board 1702 and the IC package 1732. The coupling components 1728 and 1730 may take the form of any of the embodiments of the coupling components 1716 discussed above, and the IC packages 1726 and 1732 may take the form of any of the embodiments of the IC package 1720 discussed above. The package-on-package structure 1734 may be configured in accordance with any of the package-on-package structures known in the art.

FIG. 10 is a block diagram of an example electrical device 1800 that may include one or more IC structures with a conductive via in accordance with any of the embodiments disclosed herein. For example, any suitable ones of the components of the electrical device 1800 may include one or more of the IC device assemblies 1700, IC packages 1650, IC structures 1600, or dies 1502 disclosed herein. A number of components are illustrated in FIG. 10 as included in the electrical device 1800, but any one or more of these components may be omitted or duplicated, as suitable for the application. In some embodiments, some or all of the components included in the electrical device 1800 may be attached to one or more motherboards. In some embodiments, some or all of these components are fabricated onto a single system-on-a-chip (SoC) die.

Additionally, in various embodiments, the electrical device 1800 may not include one or more of the components illustrated in FIG. 10, but the electrical device 1800 may include interface circuitry for coupling to the one or more components. For example, the electrical device 1800 may not include a display device 1806, but may include display device interface circuitry (e.g., a connector and driver circuitry) to which a display device 1806 may be coupled. In another set of examples, the electrical device 1800 may not include an audio input device 1824 or an audio output device 1808, but may include audio input or output device interface circuitry (e.g., connectors and supporting circuitry) to which an audio input device 1824 or audio output device 1808 may be coupled.

The electrical device 1800 may include a processing device 1802 (e.g., one or more processing devices). As used herein, the term "processing device" or "processor" may refer to any device or portion of a device that processes electronic data from registers and/or memory to transform that electronic data into other electronic data that may be stored in registers and/or memory. The processing device 1802 may include one or more digital signal processors (DSPs), application-specific integrated circuits (ASICs), central processing units (CPUs), graphics processing units (GPUs), cryptoprocessors (specialized processors that execute cryptographic algorithms within hardware), server processors, or any other suitable processing devices. The electrical device 1800 may include a memory 1804, which may itself include one or more memory devices such as volatile memory (e.g., dynamic RAM (DRAM)), nonvolatile memory (e.g., read-only memory (ROM)), flash memory, solid state memory, and/or a hard drive. In some embodiments, the memory 1804 may include memory that shares a die with the processing device 1802. This memory may be used as cache memory and may include embedded dynamic RAM (eDRAM) or spin transfer torque magnetic RAM (STT-MRAM).

In some embodiments, the electrical device 1800 may include a communication chip 1812 (e.g., one or more communication chips). For example, the communication chip 1812 may be configured for managing wireless communications for the transfer of data to and from the electrical device 1800. The term "wireless" and its derivatives may be used to describe circuits, devices, systems, methods, techniques, communications channels, etc., that may communicate data through the use of modulated electromagnetic radiation through a nonsolid medium. The term does not imply that the associated devices do not contain any wires, although in some embodiments they might not.

The communication chip 1812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication chip 1812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication chip 1812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication chip 1812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication chip 1812 may operate in accordance with other wireless protocols in other embodiments. The electrical device 1800 may include an antenna 1822 to facilitate wireless communications and/or to receive other wireless communications (such as AM or FM radio transmissions).

In some embodiments, the communication chip 1812 may manage wired communications, such as electrical, optical, or any other suitable communication protocols (e.g., the Ethernet). As noted above, the communication chip 1812 may include multiple communication chips. For instance, a first communication chip 1812 may be dedicated to shorter-range wireless communications such as Wi-Fi or Bluetooth, and a second communication chip 1812 may be dedicated to longer-range wireless communications such as global positioning system (GPS), EDGE, GPRS, CDMA, WiMAX, LTE, EV-DO, or others. In some embodiments, a first communication chip 1812 may be dedicated to wireless communications, and a second communication chip 1812 may be dedicated to wired communications.

The electrical device 1800 may include battery/power circuitry 1814. The battery/power circuitry 1814 may include one or more energy storage devices (e.g., batteries or capacitors) and/or circuitry for coupling components of the electrical device 1800 to an energy source separate from the electrical device 1800 (e.g., AC line power).

The electrical device 1800 may include a display device 1806 (or corresponding interface circuitry, as discussed above). The display device 1806 may include any visual indicators, such as a heads-up display, a computer monitor, a projector, a touchscreen display, a liquid crystal display (LCD), a light-emitting diode display, or a flat panel display.

The electrical device 1800 may include an audio output device 1808 (or corresponding interface circuitry, as discussed above). The audio output device 1808 may include any device that generates an audible indicator, such as speakers, headsets, or earbuds.

The electrical device 1800 may include an audio input device 1824 (or corresponding interface circuitry, as discussed above). The audio input device 1824 may include any device that generates a signal representative of a sound, such as microphones, microphone arrays, or digital instruments (e.g., instruments having a musical instrument digital interface (MIDI) output).

The electrical device 1800 may include a GPS device 1818 (or corresponding interface circuitry, as discussed above). The GPS device 1818 may be in communication with a satellite-based system and may receive a location of the electrical device 1800, as known in the art.

The electrical device 1800 may include another output device 1810 (or corresponding interface circuitry, as discussed above). Examples of the other output device 1810 may include an audio codec, a video codec, a printer, a wired or wireless transmitter for providing information to other devices, or an additional storage device.

The electrical device 1800 may include another input device 1820 (or corresponding interface circuitry, as discussed above). Examples of the other input device 1820 may include an accelerometer, a gyroscope, a compass, an image capture device, a keyboard, a cursor control device such as a mouse, a stylus, a touchpad, a bar code reader, a Quick Response (QR) code reader, any sensor, or a radio frequency identification (RFID) reader.

The electrical device 1800 may have any desired form factor, such as a handheld or mobile electrical device (e.g., a cell phone, a smart phone, a mobile internet device, a music player, a tablet computer, a laptop computer, a netbook computer, an ultrabook computer, a personal digital assistant (PDA), an ultra mobile personal computer, etc.), a desktop electrical device, a server device or other networked computing component, a printer, a scanner, a monitor, a set-top box, an entertainment control unit, a vehicle control unit, a digital camera, a digital video recorder, or a wearable electrical device. In some embodiments, the electrical device 1800 may be any other electronic device that processes data.

The following paragraphs provide various examples of the embodiments disclosed herein.

Example 1 provides an IC structure that includes a first layer including a first conductive element (e.g., a conductive via, conductive contact, or other conductive element), a second layer over the first layer, the second layer including a second conductive element, and a third layer between the first layer and the second layer. The third layer includes a conductive interconnect (e.g., via) between the first conductive element and the second conductive element. The conductive interconnect includes a first portion having a first width in a first plane substantially parallel to the first layer, a second portion having a second width in a second plane substantially parallel to the first layer, and a third portion having a third width in a third plane substantially parallel to the first layer, wherein the third portion is between the first portion and the second portion, and the third width is smaller than the first width and the second width.

Example 2 provides an IC structure according to example 1, where the conductive interconnect tapers from the first portion towards the third portion.

Example 3 provides an IC structure according to examples 1 or 2, where the conductive interconnect tapers from the second portion towards the third portion.

Example 4 provides an IC structure according to any one of examples 1-3, where the conductive interconnect includes a curved convex portion (e.g., a bulge or protuberance) between the first conductive element and the third portion.

Example 5 provides an IC structure according to any one of examples 1-4, where the first width is greater than the second width.

Example 6 provides an IC structure according to any one of examples 1-5, where a distance between the third plane and the first conductive element is at least 10% of a length of the conductive interconnect, wherein the length of the conductive interconnect is a dimension of the conductive interconnect in a direction substantially perpendicular to the first layer.

Example 7 provides an IC structure according to any one of examples 1-6, where the distance between the third plane and the first conductive element is less than 75% of length of the conductive via.

Example 8 provides an IC structure according to any one of examples 1-7, where the conductive interconnect includes a midpoint between the first conductive element and the second conductive element, and the third plane is closer to the midpoint of the conductive interconnect than to the first conductive element and the second conductive element.

Example 9 provides an IC structure including a first layer including a first conductive interconnect, a second layer over the first layer, the second layer including a second conductive interconnect, and a conductive via between the first conductive interconnect and the second conductive interconnect. The conductive via includes a bottom portion having a first width in a first plane substantially parallel to the first layer, a top portion having a second width in a second plane substantially parallel to the first layer, and a third portion having a third width in a third plane substantially parallel to the first layer, where the third portion is between the top portion and the bottom portion, and the third width is smaller than the first width and the second width.

Example 10 provides an IC structure according to example 9, where the conductive via tapers from the bottom portion towards the third portion.

Example 11 provides an IC structure according to examples 9 or 10, where the conductive via tapers from the top portion towards the third portion.

Example 12 provides an IC structure according to any one of examples 9-11, where the bottom portion includes a curved convex portion.

Example 13 provides an IC structure according to any one of examples 9-12, where the first width is greater than the second width.

Example 14 provides an IC structure according to any one of examples 9-13, where a distance between the third plane and the first conductive interconnect is at least 10% of a length of the conductive via, and where the length of the conductive via is a dimension of the conductive via in a direction substantially perpendicular to the first layer.

Example 15 provides an IC structure according to any one of examples 9-14, where the distance between the third plane and the first conductive interconnect is less than 75% of length of the conductive via.

Example 16 provides an IC structure according to any one of examples 9-15, where the conductive via includes a midpoint between the first conductive element and the second conductive element, and the third plane is closer to the midpoint of the conductive via than to the first conductive element and the second conductive element.

Example 17 provides an IC structure according to any one of examples 1-16, where the IC structure includes or is a part of a central processing unit.

Example 18 provides an IC structure according to any one of examples 1-17, where the IC structure includes or is a part of a memory device.

Example 19 provides an IC structure according to any one of examples 1-18, where the IC structure includes or is a part of a logic circuit.

Example 20 provides an IC structure according to any one of examples 1-19, where the IC structure includes or is a part of input/output circuitry.

Example 21 provides an IC structure according to any one of examples 1-20, where the IC structure includes or is a part of a field programmable gate array transceiver.

Example 22 provides an IC structure according to any one of examples 1-21, where the IC structure includes or is a part of a field programmable gate array logic.

Example 23 provides an IC structure according to any one of examples 1-22, where the IC structure includes or is a part of a power delivery circuitry.

Example 24 provides an IC package including a package substrate including a first conductive contact and an IC die. The IC die includes a first layer including a first conductive element coupled to the first conductive contact, a second layer over the first layer, the second layer including a second conductive element, and a conductive via between the first conductive element and the second conductive element, wherein the conductive via is wider at both ends than at a portion between the ends of the conductive via.

Example 25 provides for an IC package according to example 24, where the conductive via tapers from both of the ends towards the portion between the ends of the conductive via.

Example 26 provides for an IC package according to example 24 or 25, where the conductive via includes a curved convex portion at one of the ends.

Example 27 provides for an IC package according to any one of examples 24-26, where the ends of the conductive via include a first end and a second end, wherein the first end is closer to the first conductive contact than the second end, and where the first end is wider than the second end.

Example 28 provides for an IC package according to any one of examples 24-27, where the conductive via includes a midpoint between the ends, and where the portion between the ends of the conductive via that is narrower than the ends of the conductive via is closer to the midpoint than to the ends of the conductive via.

Example 29 provides for an IC package that includes an IC die including an IC structure according to any one of examples 1-23, and a further IC component, coupled to the IC die.

Example 30 provides for an IC package according to example 29 where the further IC component includes a package substrate.

Example 31 provides for an IC package according to example 29, where the further IC component includes an interposer.

Example 32 provides for an IC package according to example 29, where the further IC component includes a further IC die.

Example 33 provides a computing device that includes a carrier substrate and an IC structure coupled to the carrier substrate, where the IC structure is an IC structure according to any one of examples 1-23, or the IC structure is included in the IC package according to any one of examples 24-32.

Example 34 provides a computing device according to example 33, where the computing device is a wearable or handheld computing device.

Example 35 provides a computing device according to examples 33 or 34, where the computing device further includes one or more communication chips.

Example 36 provides a computing device according to any one of examples 33-35, where the computing device further includes an antenna.

Example 37 provides a computing device according to any one of examples 33-36, where the carrier substrate is a motherboard.

Example 38 provides a method of fabricating an IC structure including forming an opening (e.g., a via trench) in one or more layers over a first side of the IC structure (e.g., over a front side), at least partially filling the opening with a first material (e.g., partially filling the opening with a sacrificial material or filling the opening with a conductive material), flipping over the IC structure to expose a second side of the IC structure (e.g., a back side), and removing material from the second side of the substrate to reveal the first material at a bottom of the opening. The method involves at least partially removing the first material from the opening from the second side (e.g., removing the sacrificial material or partially recessing the conductive material), widening a portion of the opening from the second side, and filling the opening from the second side with a conductive material.

Example 39 provides a method according to method 38, where widening the portion of the opening includes widening the portion of the opening at or proximate to the bottom of the opening (e.g., proximate to the second side) to a width that is greater than a second portion of the opening at or proximate to a top of the opening (e.g., proximate to the first side).

Example 40 provides a method according to examples 38 or 39, where at least partially removing the first material from the bottom of the opening includes: removing the first material from a portion of the opening extending from the bottom to 5-75% of a length of the opening.

Example 41 provides a method according to any one of examples 38-40, where removing the material from the second side includes polishing the second side to reveal the first material at the bottom of the opening.

Example 42 provides a method according to any one of examples 38-41, where widening the portion of the opening includes wet etching or dry etching sidewalls of the opening exposed by at least partially removing the first material.

Example 43 provides a method according to any one of examples 38-42, further including prior to wet etching or dry etching the sidewalls, depositing a hard mask material over the second side.

Example 44 provides a method according to any one of examples 38-43, where the first material includes a conductive material (such as in the method 200 of FIG. 2), and where at least partially filling the opening with the first material includes filling the opening with a conductive material.

Example 45 provides a method according to example 44, where at least partially removing the first material from the bottom of the opening includes dry etching the conductive material from the bottom of the via trench.

Example 46 provides a method according to any one of examples 38-43, where at least partially filling the opening with the first material includes partially filling the opening with a sacrificial material (such as in the method 400 of FIG. 4).

Example 47 provides a method according to example 46, where the sacrificial material includes a carbon-based material.

Example 48 provides a method according to examples 46 or 47, further including filling the partially filled via trench with a conductive material over the sacrificial material.

Example 49 provides a method according to any one of examples 46-48, where at least partially removing the first material from the opening includes removing the first material with an ashing process.

Example 50 provides a method according to any one of examples 38-49, where the IC structure is an IC structure according to any one of examples 1-23.

The above description of illustrated implementations of the disclosure, including what is described in the Abstract, is not intended to be exhaustive or to limit the disclosure to the precise forms disclosed. While specific implementations of, and examples for, the disclosure are described herein for illustrative purposes, various equivalent modifications are possible within the scope of the disclosure, as those skilled in the relevant art will recognize. These modifications may be made to the disclosure in light of the above detailed description.

## Claims

1. An integrated circuit (IC) structure, comprising:
a first layer including a first conductive element;
a second layer over the first layer, the second layer including a second conductive element; and
a third layer between the first layer and the second layer, the third layer including a conductive interconnect between the first conductive element and the second conductive element, the conductive interconnect including:
a first portion having a first width in a first plane substantially parallel to the first layer, a second portion having a second width in a second plane substantially parallel to the first layer, and a third portion having a third width in a third plane substantially parallel to the first layer, wherein the third portion is between the first portion and the second portion, and the third width is smaller than the first width and the second width.

2. The IC structure of claim 1, wherein:
the conductive interconnect tapers from the first portion towards the third portion.

3. The IC structure of claim 2, wherein:
the conductive interconnect tapers from the second portion towards the third portion.

4. The IC structure of any one of claims 1-3, wherein:
the conductive interconnect includes a curved convex portion between the first conductive element and the third portion.

5. The IC structure of any one of claims 1-4, wherein:
the first width is greater than the second width.

6. The IC structure of any one of claims 1-5, wherein:
a distance between the third plane and the first conductive element is at least 10% of a length of the conductive interconnect, wherein the length of the conductive interconnect is a dimension of the conductive interconnect in a direction substantially perpendicular to the first layer.

7. The IC structure of claim 6, wherein:
the distance between the third plane and the first conductive element is less than 75% of a length of the conductive interconnect.

8. The IC structure of any one of claims 1-7, wherein:
the conductive interconnect includes a midpoint between the first conductive element and the second conductive element; and
the third plane is closer to the midpoint of the conductive interconnect than to the first conductive element and the second conductive element.

9. A method of fabricating an integrated circuit (IC) structure, the method comprising:
forming a via trench in one or more layers over a first side of a substrate;
at least partially filling the via trench with a material;
flipping over the substrate to expose a second side of the substrate;
removing a further material from the second side of the substrate to reveal the material at a bottom of the via trench;
at least partially removing the material from the via trench from the second side;
widening a portion of the via trench from the second side; and
filling the via trench from the second side with a conductive material.

10. The method of claim 9, wherein:
widening the portion of the via trench includes: widening the portion of the via trench at or proximate to the bottom to a width that is greater than a second portion of the via trench at or proximate to a top of the via trench.

11. The method of claims 9 or 10, wherein:
at least partially removing the material from the bottom of the via trench includes: removing the material from a portion of the via trench extending from the bottom to 5-75% of a length of the via trench.

12. The method of any one of claims 9-11, wherein:
removing the further material from the second side of the substrate includes: polishing the second side of the substrate to reveal the material at the bottom of the via trench.

13. The method of any one of claims 9-12, wherein:
widening the portion of the via trench includes: wet etching or dry etching sidewalls of the via trench exposed by at least partially removing the material.

14. The method of claim 13, further comprising:
prior to wet etching or dry etching the sidewalls, depositing a hard mask material over second side.

15. The method of any one of claims 9-14, wherein:
the material includes a conductive material; and
at least partially filling the bottom of the via trench with the material includes: filling the via trench with the conductive material.
